# EUROPEAN PATENT APPLICATION

(11) **EP 1 806 770 A1**
(43) Date of publication of application: **11.07.2007**
(21) Application number: 06729246.6
(22) Date of filing: 16.03.2006
(51) Int. Cl.: H01L 21/02, C30B 25/04, C30B 29/38, H01L 21/20

(54) **GALLIUM NITRIDE WAFER**

(30) Priority: 21.07.2005 JP 2005211749
(71) Applicant: Sumitomo Electric Industries, Ltd., Osaka-shi, Osaka 541 (JP)
(72) Inventor: NAKAYAMA, Masahiro c/o Itami Works of Sumitomo, Itami-shi, Hyogo 6640016 (JP)
(74) Representative: Grünecker, Kinkeldey, Stockmair & Schwanhäusser Anwaltssozietät
(86) International application number: PCT/JP2006/305253
(87) International publication number: WO 2007/010645

(57) **Abstract**

A gallium nitride wafer 11 has a substantially circular shape. The gallium nitride wafer 11 includes a plurality of stripe regions 13, a plurality of single crystal regions 15, and a visible mark 17. Each stripe region 13 represents the direction of <11-20> axis and extends in a direction of a predetermined axis. Each stripe region 13 is interposed between single crystal regions 15. The mark 17 is provided in at least one of front side 11a and back side 11b of the gallium nitride wafer 11, and has a visible size and shape. A dislocation density of the stripe regions 13 is larger than that of the single-crystal regions 15, and the crystal orientation of the stripe regions 13 is different from that of the single crystal regions 15.

## Description

### Technical Field

The present invention relates to a gallium nitride wafer.

### Background Art

Patent Document 1 (Japanese Patent Application Laid-Open No. 10-135164) describes a method of producing a semiconductor wafer by slicing a silicon semiconductor ingot. The method is as follows. Surfaces of a silicon wafer formed as above are planarized. The planarized silicon wafer is subjected to alkali etching. The etched silicon wafer is polished by a double-side polishing machine so that the front side of the silicon wafer becomes a mirror-finished surface and so that the back side is polished so as to leave irregularities for permitting discrimination between the two sides. The double-side-polished silicon wafer is then cleaned. This production method of semiconductor wafer enables efficient production of the silicon wafer, the back side of which has the irregularities for permitting discrimination between the two sides, in a uniform thickness and without any influence of the back side on the front side.

Patent Document 2 (Japanese Patent Application Laid-Open No. 2001-167993) describes a semiconductor wafer made of a GaAs, InP, InSb, InAs, or GaP semiconductor and permitting discrimination between the two sides. In a notched semiconductor wafer having a notch in its peripheral part, the surface roughness of a chamfer in the peripheral part of one surface thereof is different from that of a chamfer in the notch. The surface roughness of a chamfer in the peripheral part of the other surface is equivalent to that of the chamfer in the notch. If illuminating the notched semiconductor wafer, then the gloss at the chamfer in the peripheral part on the one surface side of the compound wafer is different from that at the chamfer in the notch, and the gloss at the chamfer in the peripheral part on the other surface side is equivalent to that at the chamfer in the notch, which enables visual discrimination between the two sides.

Patent Document 3 (Japanese Patent Application Laid-Open No. 2002-15966) describes a semiconductor wafer made of a GaAs, InP, InSb, InAs, or GaP semiconductor and permitting accurate discrimination between the two sides. The semiconductor wafer of a disk shape has a notch in a part of the outer periphery, and this notch is chamfered from the both sides in order to discriminate the crystal orientation and is formed so that an inclination angle of the chamfer of the front side is different from that of the back side.

Patent Document 4 (Japanese Patent Application Laid-Open No. 2002-222746) describes a nitride semiconductor wafer permitting easy discrimination of crystal face orientations and the like. A GaN substrate has the primary surface of (0001) plane and has an orientation flat for discriminating <1-100> equivalent directions.
Patent Document 1: Japanese Patent Application Laid-Open No. H10-135164
Patent Document 2: Japanese Patent Application Laid-Open No. 2001-167993
Patent Document 3: Japanese Patent Application Laid-Open No. 2002-15966
Patent Document 4: Japanese Patent Application Laid-Open No. 2002-222746

### Disclosure of the Invention

### Problem to be Solved by the Invention

In Patent Document 1, the front side is discriminated from the back side by the different irregularities between the front and back sides of the silicon substrate. However, gallium nitride is transparent to visible light and, when the front side of a gallium nitride wafer is observed, reflected components of light from the front side and back side both are observed. Therefore, if the roughness of the back side is large in a ground-glass appearance even where the roughness of the front side is small in a mirror-finished appearance, the reflected component of light from the back side is also observed. Accordingly, it is not always the case that the front side can be readily discriminated from the back side by simply differentiating the roughness of the front side from that of the back side.

In Patent Document 2 and Patent Document 3, the front and back of the semiconductor wafer can be discriminated from each other in wafers made of GaAs, InP, InSb, InAs or GaP semiconductor, but, unlike these semiconductors, gallium nitride is transparent to visible light and the crystal symmetry of these semiconductors is different from that of gallium nitride.

Document 4 discloses the method for discriminating the front and back of the circular wafer by laser marking. It discloses that a character string is marked in parallel with a cleavage line by laser marking to discriminate cleavage lines. However, it is not easy to discriminate the cleavage line by use of a short character string and it is necessary to define the parallelism of the character string. Accordingly, there remains unsatisfactory accuracy of exposed patterns when semiconductor lasers are fabricated on this circular wafer. Patent Document 4 also discloses that an asymmetric notch is formed in a cleavage surface in order to discriminate the front and back of the circular wafer, and a crack may occur along the cleavage line unless adequate attention is paid to a notch forming work.

The present invention has been accomplished in view of the above-described concerns and it is an object of the invention to provide a gallium nitride wafer permitting the discrimination of the front side and back side thereof from each other.

### Means for Solving the Problem

One aspect of the present invention relates to a gallium nitride wafer of a substantially circular. This gallium nitride wafer comprises: (a) a plurality of stripe regions representing a direction of one crystal axis of <11-20> axis and <1-100> axis and extending in a direction of a predetermined axis, (b) a plurality of single crystal regions separated from each other by the stripe regions, and (c) a visible mark provided in at least one of a front side and a back side of the gallium nitride wafer. The stripe regions and the single-crystal regions appear on the front side of the gallium nitride wafer, a dislocation density of the stripe regions is larger than a dislocation density of the single crystal regions, and a crystal orientation of the stripe regions is different from a crystal orientation of the single crystal regions

In this gallium nitride wafer, the direction of the crystal axis of the wafer can be discriminated by use of the stripe regions, and the front and back of the wafer can be discriminated from each other by the mark.

In the gallium nitride wafer of the present invention, preferably, the predetermined axis makes an angle equal to or less than 0.1 degrees with reference to one crystal axis of <11-20> axis and <1-100> axis. In this gallium nitride wafer, semiconductor devices can be aligned on the wafer in association with the stripe regions, whereby the orientation of the semiconductor devices can be associated with a cleavage line with high accuracy.

In the gallium nitride wafer of the present invention, preferably, the predetermined axis makes an angle equal to or less than 0.03 degrees with reference to one crystal axis of <11-20> axis and <1-100> axis. In this gallium nitride wafer, the stripe regions can be oriented in alignment with the predetermined crystal axis with very high accuracy in fabrication of the gallium nitride wafer.

In the gallium nitride wafer of the present invention, preferably, the mark is provided on the back side of (000-1) plane of the gallium nitride wafer. This gallium nitride wafer requires no region for the mark for the front side in which semiconductor devices are to be fabricated. In the gallium nitride wafer of the present invention, preferably, the mark is provided on the front side of (0001) plane of the gallium nitride wafer.

In the gallium nitride wafer of the present invention, preferably, the front side of the gallium nitride wafer is inclined at a certain off-angle with reference to a predetermined crystal axis, and the mark is provided at a position for specifying the direction of the above inclination with reference to the predetermined crystal axis.

In this gallium nitride wafer, the direction of the off-angle of the off-angled substrate can be discriminated using the visible mark provided in either of the front side and the back side.

In the gallium nitride wafer of the present invention, preferably, the mark is formed by irradiation with a laser beam. In this gallium nitride wafer, the visible mark can be readily made with the laser beam.

Another aspect of the present invention relates to a gallium nitride wafer having an edge of circular arc. The gallium nitride wafer comprises: (a) a plurality of stripe regions representing a direction of one crystal axis of < 11-20> axis and < 1-100> axis and extending in a direction of a predetermined axis, (b) a plurality of single crystal regions separated from each other by the stripe regions, and (c) a cut portion provided at the edge of the gallium nitride wafer. The stripe regions and the single crystal regions appear on a front side of the gallium nitride wafer, a dislocation density of the stripe regions is larger than a dislocation density of the single-crystal regions, a crystal orientation of the stripe regions is different from a crystal orientation of the single-crystal regions, the cut portion is located at the edge within either of the following center angle region with respect to a first reference line: not less than +10 degrees nor more than +80 degrees; not less than -10 degrees nor more than -80 degrees, and the first reference line extends substantially parallel or substantially perpendicular to the stripe regions and passes through a center of the gallium nitride wafer.

In this gallium nitride wafer, the direction of the crystal axis of the wafer can be discriminated by the stripe regions, and the front and back of the wafer can be discriminated from each other by the cut portion.

In the gallium nitride wafer of the present invention, preferably, the cut portion has a notch shape. In this gallium nitride wafer, the notch is provided in a direction deviating from a cleavage line, and thus the gallium nitride wafer is less likely to be broken because of the notch.

In the gallium nitride wafer of the present invention, preferably, the cut portion is an orientation flat and the orientation flat extends along a second reference line intersecting with the first reference line. In this gallium nitride wafer, the orientation flat is provided in a direction deviating from a cleavage line, and thus the gallium nitride wafer is less likely to be broken because of the orientation flat.

In the gallium nitride wafer of the present invention, preferably, a length of the orientation flat is equal to or more than 5 mm. In the wafer of inch size, the orientation flat is visible.

The above object and other objects, features, and advantages of the present invention will become apparent more readily in view of the following detailed description of the preferred embodiments of the present invention with reference to the accompanying drawings.

### Effect of the Invention

As described above, the present invention provides the gallium nitride wafer permitting discrimination of the front side and back side thereof.

### Brief Description of the Drawings

Fig. 1 is a view showing a gallium nitride wafer according to an embodiment of the present invention. Parts (A) and (B) show gallium nitride wafers according to the embodiments.
Fig. 2 is a view showing a gallium nitride wafer. Part (A) shows a cross section taken along line I-I shown in part (A) of Fig. 1. Parts (B) and (C) of Fig. 2 shows marks provided in the front side of a wafer and a mark in the back side thereof, respectively.
Fig. 3 is a view showing the relationship of an angle between stripe regions and a predetermined crystal axis.
Fig. 4 is a view showing a gallium nitride wafer. Part (A) of Fig. 4 shows a gallium nitride wafer according to a second embodiment of the present invention, and part (B) shows an example of a notch, as a magnification of the part of the figure enclosed in a dashed circle drawn in part (A) of Fig. 4.
Fig. 5 is a view showing a gallium nitride wafer according to a third embodiment of the present invention. Part (A) of Fig. 5 shows a gallium nitride wafer, and part (B) of Fig. 5 shows another example of a notch, as a magnification of the part of the figure enclosed in a dashed circle drawn in part (A) of Fig. 4.
Fig. 6 is a view showing a gallium nitride wafer according to a fourth embodiment of the present invention. Part (A) of Fig. 6 shows a gallium nitride wafer, and part (B) of Fig. 6 is a view showing a cross section along line II-II shown in part (A) of Fig. 6.

### Description of Reference Symbols

11,21,31,41,51: gallium nitride wafer;
13, 23, 33, 43, 53: stripe regions;
15, 25, 35, 45, 55: single-crystal regions;
17, 27: visible mark;
11a, 21a, 31a, 51a: front side of gallium nitride wafer;
11b, 21b, 31b, 51b: back side of gallium nitride wafer;
37 or 47: cut portion;
Ref1, Ref2, and Ref3: reference lines;
O: center of gallium wafer;
Anglel-Angle4: angular areas;
41c: arcuate edge;
Angle_{OFF}: off angle.

### Best Mode for Carrying out the Invention

The teachings of the present invention will readily be understood in view of the following detailed description with reference to the accompanying drawings illustrated by way of example. Referring to the accompanying drawings, embodiments of a gallium nitride wafer of the present invention will be explained. When possible, parts identical to each other will be referred to with symbols identical to each other.

### (First Embodiment)

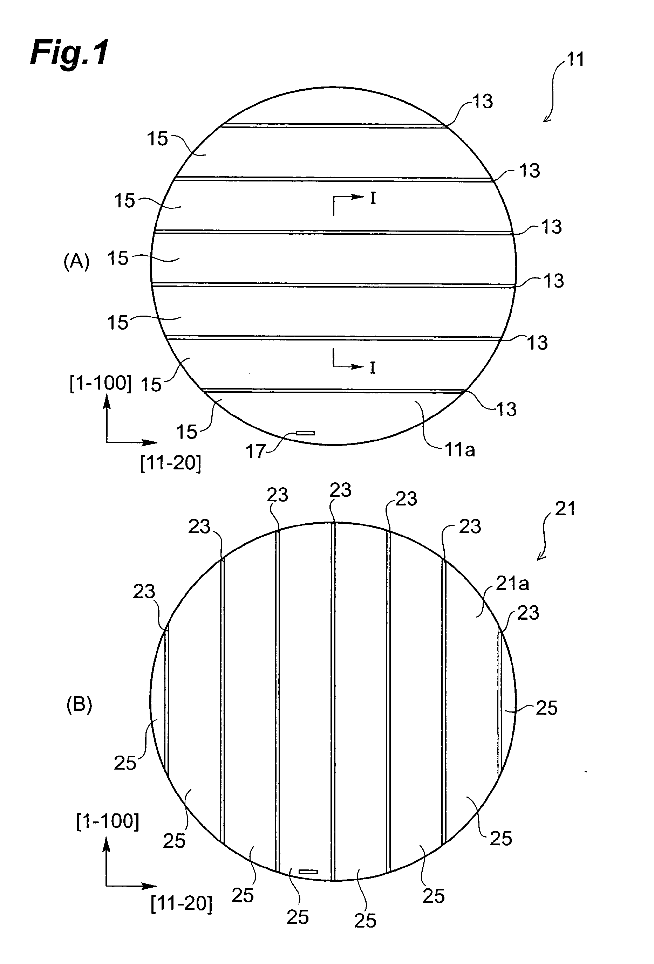

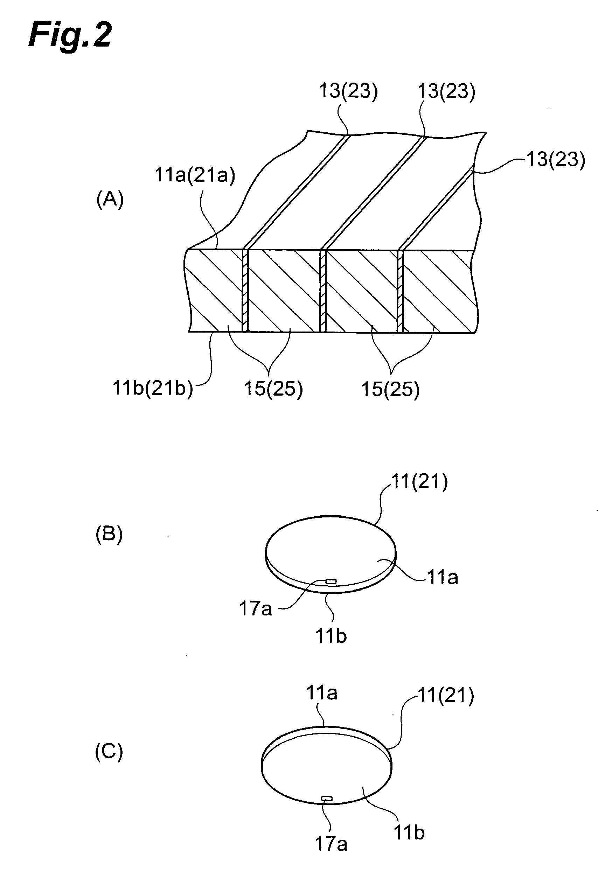

Part (A) of Fig. 1 shows a gallium nitride wafer in an embodiment of the present invention. Part (A) of Fig. 2 shows a cross section taken along line I-I shown in part (A) of Fig. 1. Parts (B) and (C) of Fig. 2 show marks provided in the front side and in the back side of a wafer, respectively. This gallium nitride wafer 11 has a substantially circular shape. The gallium nitride wafer 11 includes a plurality of stripe regions 13, a plurality of single crystal regions 15, and a visible mark 17. Each stripe region 13 represents a direction of the <11-20> axis and extends in a direction of a predetermined axis. The single-crystal regions 15 are separated from each other by the stripe regions 13. Each stripe region 13 is interposed between the single crystal regions 15, and the gallium nitride wafer 11 includes the plurality of stripe regions 13 and the plurality of single crystal regions 15 and is of a free-standing shape. As shown in parts (B) and (C) of Fig. 2, the mark 17 is provided in at least one of front side 11a and back side 11b of the gallium nitride wafer 11, and has a visible size and shape.

Part (B) of Fig. 1 shows a gallium nitride wafer in an embodiment of the present invention. With reference to part (B) of Fig. 1, this gallium nitride wafer 21 has a substantially circular shape. The gallium nitride wafer 21 includes a plurality of stripe regions 23, a plurality of single crystal regions 25, and a visible mark 27. Each stripe region 23 represents a direction of the <1-100> axis and extends in a direction of a predetermined axis. In the gallium nitride wafer 21, as in the gallium nitride wafer 11, the single crystal regions 25 are also separated from each other by the stripe regions 23. The mark 27 is provided in at least one of the front side and back side of the gallium nitride wafer.

As shown in part (A) of Fig. 2, the stripe regions 13 and single crystal regions 15 appear on the front side 11a and on the back side 11b of the gallium nitride wafer 11. The dislocation density of the stripe regions 13 is larger than that of the single crystal regions 15, and the crystal orientation of the stripe regions 13 is different from that of the single-crystal regions 15. For example, in the case of the gallium nitride wafer having (0001) plane, the front side of the gallium nitride wafer 11 has nitride (N) faces and gallium (Ga) faces which correspond to the stripe regions 13 and the single crystal regions 15. In the front side of the gallium nitride wafer 11, the width of the stripe regions 13 is, for example, approximately 10-50 micrometers and the width of the single crystal regions 15, for example, approximately 300-600 micrometers. The stripe regions 13 and single-crystal regions 15 are alternately arranged.

In this gallium nitride wafer 11 (21), the direction of the crystal axis of the wafer can be discriminated by the stripe regions 13 (23) and the front and back of the wafer 11 (21) can be discriminated from each other by use of the mark 17 (27). Semiconductor devices can be fabricated on the wafer in alignment with the predetermined crystal axis by use of the stripe regions 13 (23) and the semiconductor devices fabricated on the wafer can be separated by cleavage into a plurality of semiconductor dies. For example, in the case of a light-emitting device, such as semiconductor lasers, the active region is provided on the single crystal regions 15 (25) and oriented in the direction of the stripe regions 13 (23), and the facets are formed by cleavage as accurately oriented relative to the active region.

The gallium nitride wafers described above are fabricated, for example, as follows. Prior to formation of a thick film of gallium nitride, a mask with a predetermined pattern (e.g., stripe pattern) is provided on a GaAs substrate of a desired size (e.g., 2 inches). A thick film of gallium nitride is deposited on this substrate by HVPE method. One or more gallium nitride wafers are fabricated from the thick film of gallium nitride by slicing it.

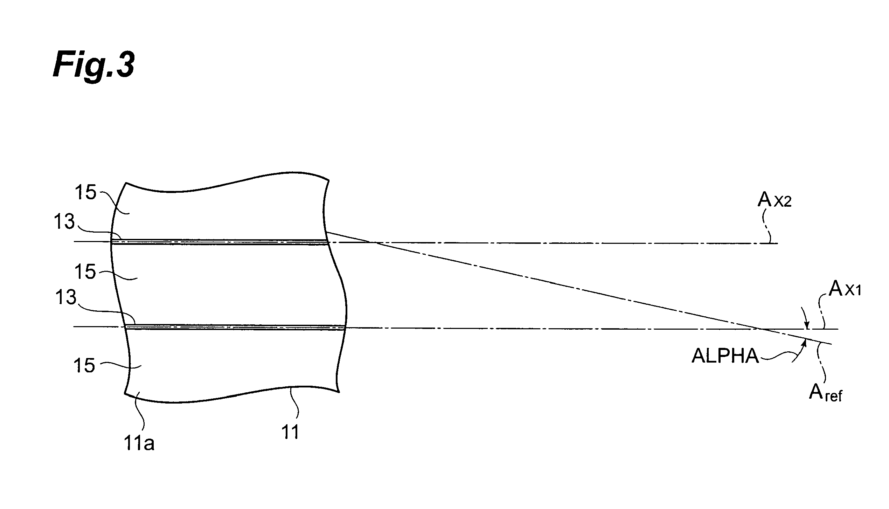

Fig. 3 is a view showing the relationship of the angle between the stripe regions and the predetermined crystal axis. The subsequent explanation will be given with reference to the gallium nitride wafer 11, but this description can be also applied similarly to the gallium nitride wafer 21 except for the description about the direction in which the stripe regions 13 extend. The gallium nitride wafer 11 is fabricated so that the stripe regions 13 extend along respective axes Ax1, Ax2 each making an angle "ALPHA"of not more than 0.1 degrees with respect to a reference line A_{ref} indicating the direction of <11-20> axis (or <1-100> axis). In this gallium nitride wafer 11, semiconductor devices can be aligned on the wafer in association with the direction in which the stripe regions extend, whereby the semiconductor devices can be associated with the orientation of the cleavage surface with high accuracy. Since the stripe regions appearing on the front side of gallium nitride wafer 11 are arrayed substantially in parallel, an angle which the axis Ax1 (axis along which a certain stripe region 13 extends) forms with the reference line A_{ref} and an angle which the axis Ax2 (axis along which another stripe region 13 extends) forms with the reference line A_{ref} both are within 0.1 degrees. Furthermore, the gallium nitride wafer 11 can be fabricated so that the aforementioned angle "ALPHA" is within 0.03 degrees, whereby the stripe regions 11 can be oriented with very high accuracy.

The mark 17 can be provided in the front side 11a of the gallium nitride wafer 11, as shown part (B) in Fig. 2. The mark 17 is preferably provided in the back side 11b of the gallium nitride wafer 11, as shown in part (C) of Fig. 2. This gallium nitride wafer 11 does not need any region for the mark in the front side on which semiconductor devices are to be fabricated. The mark 17 is preferably formed by irradiation with a laser beam. By use of a laser beam, a visible mark can be readily formed in gallium nitride wafers transparent to visible light.

### (Example 1)

Laser marking is performed using a carbon dioxide laser. Dots are formed on a wafer with pulsed laser beam having the peak power of 170 Watts and the pulse width of 100 µsec (irradiation power per pulse: 17 mJ). A symbol string, such as a character string for a lot number, composed of a plurality of dots for the string each having the diameter of about 110 µm can be marked. Since a lot number is expressed by a plurality of characters and this string does not have any axial symmetry, it is available to discriminate the one side of the wafer from the other, i.e. the front or back, on which the mark is formed even if the wafer is made of gallium nitride transparent to visible light.

As described above, the first embodiment provides the gallium nitride wafer permitting discrimination between the two sides of the wafer of gallium nitride transparent to visible light.

### (Second Embodiment)

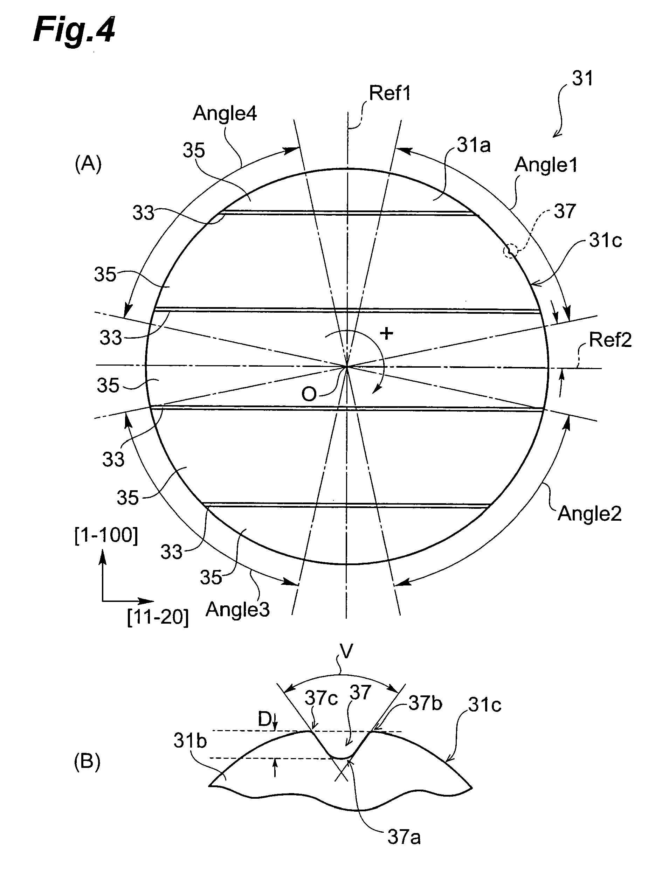

Part (A) of Fig. 4 shows a gallium nitride wafer in the second embodiment. This gallium nitride wafer 31 has an edge of a circular arc. The gallium nitride wafer 31 includes a plurality of stripe regions 33, a plurality of single crystal regions 35, and a visible cut portion 37. Each stripe region 33 represents a direction of <11-20> axis and extends in the direction of a predetermined axis. Each stripe region 33 is interposed between the single crystal regions 35. The stripe regions 33 and the single crystal regions 35 appear on the front side 31a and on the back side 31b of the gallium nitride wafer 31. Although description will not be given with reference to drawings, the description in the present embodiment can be also applied to a gallium nitride wafer in which each stripe region represents the direction of the <1-100> axis and extends in a direction of a predetermined axis.

With reference to part (A) of Fig. 4, reference lines Ref1, Ref2 extend so as to be substantially perpendicular or substantially parallel to the stripe regions 33, and pass through on the center "O" of the gallium nitride wafer 31. The cut portion 37 is provided in an edge 31c in either of the ranges of the center angle with respect to the reference line Ref1 or Ref2: the range of not less than +10 degrees nor more than +80 degrees; and the range of not less than -10 degrees nor more than -80 degrees. Namely, the cut portion 37 is located in any one of segments Anglel-Angle4 shown in part (A) of Fig. 4. When the clockwise direction is referred to as a positive direction, the cut portion 37 is formed in any one of the following angular regions.
Angle1: 10° to 80°
Angle2: -10° to -80°
Angle3: 10° to 80°
Angle4: -10° to -80°
In the present embodiment the cut portion 37 is formed in the segment Angle 1.

In this gallium nitride wafer 31, the direction of the crystal axis of the wafer 31 can be discriminated by the stripe regions 33, and the front and back of the wafer can be discriminated by the cut portion 37.

Part (B) of Fig. 4 is a drawing showing an example of the cut portion, as a magnification of the part of the figure enclosed in a dashed circle drawn in part (A) of Fig. 4. In the example, as shown in part (B) of Fig. 4, it is preferable that the cut portion 37 have a notch shape. The notch "NOTCH" also appears on the front side 41a and on the back side 41b of the wafer. In this gallium nitride wafer 31, the notch "NOTCH" is provided in a direction deviating from the cleavage direction, and thus the gallium nitride wafer 31 is less likely to be broken during fabrication of the notch "NOTCH". This notch is made, for example, by use of a grind stone. In an example of the fabrication of the notch, the peripheral speed of the grind stone is 1500 m/min and the grind stone used is #2000. The notch angle "V" is 90 degrees, the depth "D" of the notch is 1 mm, the radius of curvature of a bottom 37a of a groove of the notch is 1 mm, and each of connections 37b, 37c between the groove of the notch and the arcuate edge is a curved surface with the radius of curvature of 0.3 mm.

As described above, the second embodiment provides the gallium nitride wafer permitting discrimination between the two sides of the wafer of gallium nitride transparent to visible light.

### (Third Embodiment)

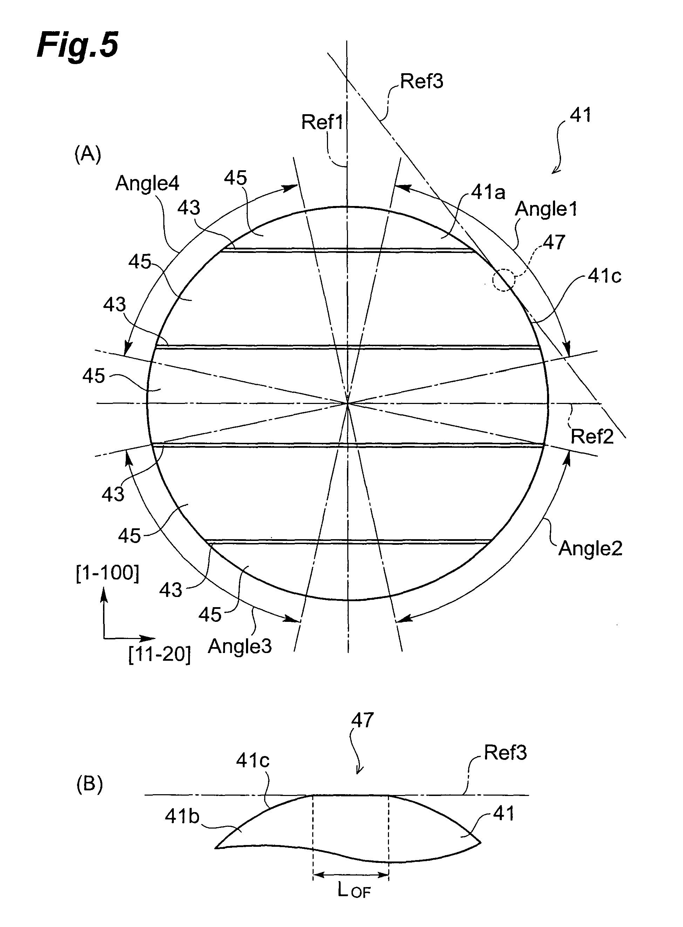

Part (A) of Fig. 5 shows a gallium nitride wafer in the third embodiment. Part (B) of Fig. 5 is a drawing showing another example of the cut portion, as a magnification of the part of the figure enclosed in a dashed circle drawn in part (A) of Fig. 5. The gallium nitride wafer 41 has the same structure as the gallium nitride wafer 31 except for the shape of the cut portion, and the gallium nitride wafer 41 includes an edge 41 c of a circular arc, a plurality of stripe regions 43, a plurality of single crystal regions 45, and a visible cut portion 47. In the example, as shown in Part (B) of Fig. 5, the cut portion 47 is preferably an orientation flat "OF" extending along a third reference line Ref3 intersecting with both first and second reference lines Ref1, Ref2. The orientation flat "OF" also appears on the front side 41a and on the back side 41b of the wafer. Since this gallium nitride wafer is provided with the orientation flat in a direction deviating from cleavage directions, the gallium nitride wafer is less likely to be broken during fabrication of the orientation flat. The length "L_{OF}" of the orientation flat "OF" is preferably not less than 5 mm, and the orientation flat can be visually recognized in the wafer of inch size.

As described above, the third embodiment provides the gallium nitride wafer permitting discrimination between the two sides of the wafer of gallium nitride transparent to the visible light.

### (Fourth Embodiment)

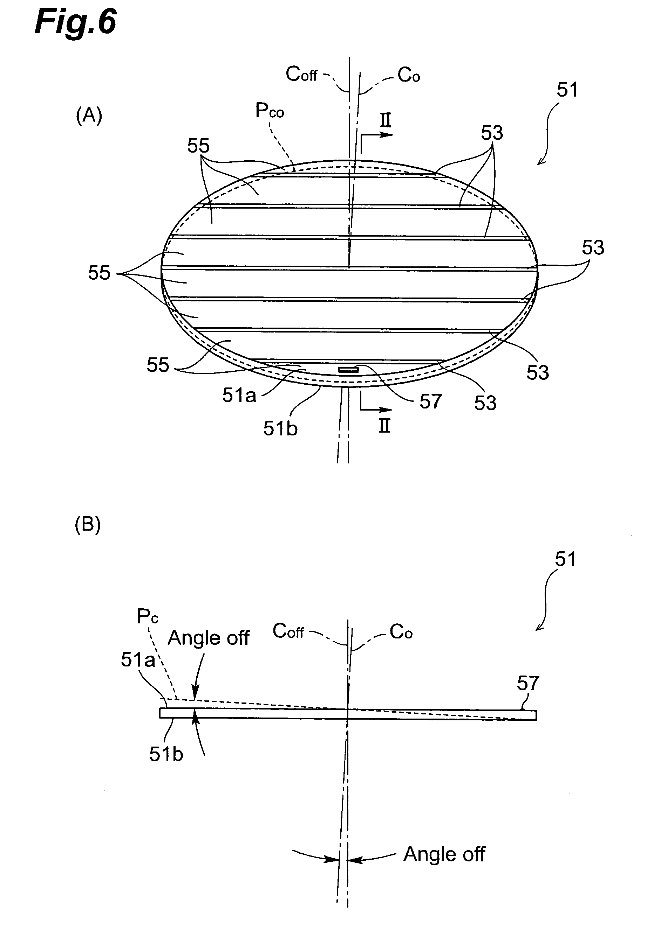

Part (A) of Fig. 6 is a drawing showing a gallium nitride wafer in the fourth embodiment. Part (B) of Fig. 6 is a drawing showing a cross section along line II-II shown in part (A) of Fig. 6. This gallium nitride wafer 51 has a substantially circular shape. The gallium nitride wafer 51 includes a plurality of stripe regions 53, a plurality of single crystal regions 55, and a visible mark 57. Each stripe region 53 represents the direction of <11-20> axis and extends along a predetermined axis for the direction. The single crystal regions 55 are separated from each other by the stripe regions 53. Each stripe region 53 is interposed between single-crystal regions 55 and the gallium nitride wafer 51 includes the plurality of stripe regions 53 and the plurality of single crystal regions 55 and is of a free-standing shape. The mark 57 is provided in at least one of front side 51a and back side 51b of the gallium nitride wafer 51, and has a visible size and shape.

An axis " C_{OFF}" indicates a direction of a normal to the front side 51a of the gallium nitride wafer 51. An angle "Angle_{OFF}" is made between the axis "C_{OFF}" and the crystal axis "C₀." The front side 51a of the gallium nitride wafer 51 is inclined at an off-angle with respect to the predetermined crystal axis "C₀." This off-angle "Angle_{OFF}" is, for example, in the range of approximately 0.05 degrees to 1.0 degree. A dashed line "P_{C0}" indicates a plane perpendicular to the crystal axis "C₀" (imaginary plane corresponding to the crystal axis "C₀").
The mark 57 is provided at a position where the mark 57 can specify this inclination direction for the front side 51a with reference to the predetermined crystal axis "C₀." In the present embodiment the mark 57 intersects with a plane defined by the axis "C_{OFF}" and the crystal axis "C₀," but the position of the mark 57 does not have to be limited to this specific example, and the mark 57 may be provided at the position of 90 degrees clockwise or counterclockwise rotation with reference to the inclination direction, for example. In a preferred example, the crystal axis "C₀" is selected as the c-axis. The axis C_{OFF} is inclined at an angle in the range of Angle_{OFF} = 0.05 degrees to 1.0 degree with reference to the crystal axis "C₀ᵥ." The mark 57 indicates the direction in which the front side 51a of the gallium nitride wafer 51 is inclined with reference to the c-plane of gallium nitride. This permits the discrimination of the inclination direction of c-axis of the gallium nitride wafer.

In general, in order to control steps and defects of atomic level in the front side of the substrate during epitaxial growth on the substrate, an off-angled substrate whose principal surface is slightly inclined from a predetermined crystal orientation may be used. For example, where the primary surface of a gallium nitride wafer is slightly inclined from the (0001) plane in a direction of a specific crystal plane, it may be impossible to discriminate the direction of the specific crystal plane in the gallium nitride wafer. Since the gallium nitride wafer of the present embodiment is provided with the mark at the specific position on the primary surface, the direction of the slight inclination can be specified thereby. Of course, it is also possible similarly to provide the mark at a specific position on the primary surface from the (000-1) plane.

Since a gallium nitride wafer is expensive, there are desires for a larger-size wafer from which much more semiconductor dies can be produced. Since gallium nitride is a highly brittle material, if a flat or the like is formed in the peripheral part of the wafer, a crack is likely to run vertically from that portion by virtue of heat, mechanical shock, or the like introduced in a subsequent process. Therefore, a substrate of circular shape is required for GaN. On the other hand, a flat has been used heretofore in order to achieve the discrimination of the cleavage surface and the discrimination between the two sides. The first and second embodiments of the present invention enable the identification of the cleavage surface and the discrimination between the two sides in the wafers of a substantially circular shape. Although the wafer of the third embodiment does not have a perfect circle shape, it permits the identification of the cleavage surface and the discrimination between the two sides even with only one flat formed in the outer periphery. A small number of flats in the outer periphery does not reduce an area of the primary surface for forming semiconductor devices.

Having described and illustrated the principle of the invention in a preferred embodiment thereof, it is appreciated by those having skill in the art that the invention can be modified in arrangement and detail without departing from such principles. Details of structures of these devices can be modified as necessary. The present invention is not limited to the specific examples disclosed in the embodiments. We therefore claim all modifications and variations coming within the spirit and scope of the following claims.

## Claims

1. A substantially circular gallium nitride wafer, comprising:
a plurality of stripe regions representing a direction of one crystal axis of <11-20> axis and <1-100> axis and extending in a direction of a predetermined axis;
a plurality of single crystal regions separated from each other by the stripe regions, the stripe regions and the single-crystal regions appearing on the front side of the gallium nitride wafer, a dislocation density of the stripe regions being larger than a dislocation density of the single crystal regions, and a crystal orientation of the stripe regions being different from a crystal orientation of the single crystal regions; and
a visible mark provided in at least one of a front side and a back side of the gallium nitride wafer.

2. The gallium nitride wafer according to Claim 1, wherein the predetermined axis makes an angle with reference to one crystal axis of <11-20> axis and <1-100> axis and the angle is within 0.1 degrees (inclusive).

3. The gallium nitride wafer according to Claim 1, wherein the predetermined axis makes an angle with reference to one crystal axis of <11-20> axis and <1-100> axis, and the angle is within 0.03 degrees (inclusive).

4. The gallium nitride wafer according to any one of Claims 1 to 3, wherein the mark is provided on the back side of (000-1) plane of the gallium nitride wafer.

5. The gallium nitride wafer according to any one of Claims 1 to 3, wherein the mark is provided on the front side of (0001) plane of the gallium nitride wafer.

6. The gallium nitride wafer according to any one of Claims 1 to 5, wherein the front side of the gallium nitride wafer is inclined at a certain off-angle with reference to a predetermined crystal axis, and
wherein the mark is provided at a position for specifying a direction of the inclination with reference to the predetermined crystal axis.

7. The gallium nitride wafer according to any one of Claims 1 to 6, wherein the mark is formed by irradiation with a laser.

8. A gallium nitride wafer having an edge of circular arc, comprising:
a plurality of stripe regions representing a direction of one of <11-20> axis and <1-100> axis and extending in a direction of a predetermined axis;
a plurality of single crystal regions separated from each other by the stripe regions, the stripe regions and the single crystal regions appearing on a front side of the gallium nitride wafer, a dislocation density of the stripe regions being larger than a dislocation density of the single crystal regions, and a crystal orientation of the stripe regions being different from a crystal orientation of the single crystal regions; and
a cut portion provided at the edge of the gallium nitride wafer, the cut portion being located at the edge within either of the following center angle range with respect to a first reference line: not less than +10 degrees nor more than +80 degrees; not less than -10 degrees nor more than -80 degrees, the first reference line extending substantially parallel or substantially perpendicular to the stripe regions and passing through a center of the gallium nitride wafer.

9. The gallium nitride wafer according to Claim 8, wherein the cut portion has a notch shape.

10. The gallium nitride wafer according to Claim 8, wherein the cut portion is an orientation flat and the orientation flat extends along a second reference line intersecting with the first reference line.

11. The gallium nitride wafer according to Claim 10, wherein a length of the orientation flat is not less than 5 mm.
